# EUROPEAN PATENT SPECIFICATION

(11) **EP 1 826 766 B1**
(45) Date of publication and mention of the grant of the patent: **30.09.2009**
(21) Application number: 06425124.2
(22) Date of filing: 28.02.2006
(51) Int. Cl.: G11C 5/14, G05F 3/20

(54) **Circuit and method for generating a controlled current and suppressing disturbance thereof**
Vorrichtung und Verfahren zur Erzeugung gesteuerten Stroms und zur Unterdrückung seiner Störungen
Circuit et procédé pour produire du courant regulé et pour supprimer les perturbations subies

(43) Date of publication of application: 29.08.2007
(73) Proprietor: STMicroelectronics S.r.l., 20041 Agrate Brianza (Milano) (IT)
(72) Inventor: Vimercati, Daniele, 20048 Carate Brianza (MI) (IT); Bolandrina, Efrem, 24020 Fiorano al Serio (BG) (IT); Garofalo, Pierguido, 20097 San Donato Milanese (MI) (IT)
(74) Representative: Niederkofler, Oswald

(56) References cited:
- EP-A- 0 891 045
- US-A1- 2005 117 408

## Description

### Field of application

The present invention generally relates to suppressing disturbances on a reference line. In particular, the present invention relates to a method for generating a controlled current by means of a bandgap circuitry, and to a circuit for suppressing disturbances and to a bandgap circuitry for generating a controlled current.

The invention particularly, but not exclusively, also relates to the generation of a controlled current signal for banks of sense amplifiers in memory devices of the so called "Dual Work type" and the following description is made with reference to this field of application in order to simplify its disclosure.

### Prior art

As it is well known, memory devices of the flash EPROM type, so called Dual Work type", have the possibility of simultaneously and independently reading on two different memory partitions, a first partition under real reading condition and a second partition under verify after modification condition.

Thus, these devices need a sense amplifier structure with high parallelism for having a high flow of output data. In particular, these sense amplifiers are organised in banks.

It is also known that each sense amplifier uses, for its operation, a reference voltage that is stable in power supply and temperature which is the bandgap voltage (in the following "Band Gap voltage" and indicated as "BGAP voltage"). This BGAP voltage is usually generated by a so called bandgap reference voltage generator, normally inside the memory device.

During the operation of the memory device, the switch on of a bank of sense amplifiers produces a transient disturb or disturbance on the Band Gap voltage BGAP, which in turn affects the performances of another bank of sense amplifiers that maybe already in a on state. In general, this cross disturb phenomenon is real also in the case of single sense amplifiers.

More in detail, inside a sense amplifier the Band Gap voltage BGAP of is generally used for generating a controlled current, i.e. a current showing a desired progress in temperature and power supply.

To the purpose, it is known to use a transient of the MOS type with N channel, in particular of the low voltage type (indicated as "LV transistor") degenerated in correspondence with its source terminal by a degeneration resistor. This LV transistor has a gate terminal controlled by the Band Gap voltage BGAP.

The degeneration resistor and the LV transistor are selected so as to obtain a controlled progress of the current thus generated with respect to variations of current and power supply, this progress being established for example on the basis of the needs of the memory device design.

The so obtained controlled current is then drawn from a current mirror, usually realised with MOS transistors with P channel and used in the sense amplifier, in any circuit node inside it where a controlled current signal is requested.

To avoid that the sense amplifier consumes also when it is not used, due to this controlled current generator, this current mirror is also equipped with enable switches, also these latter being usually realised by means of P channel MOS transistors.

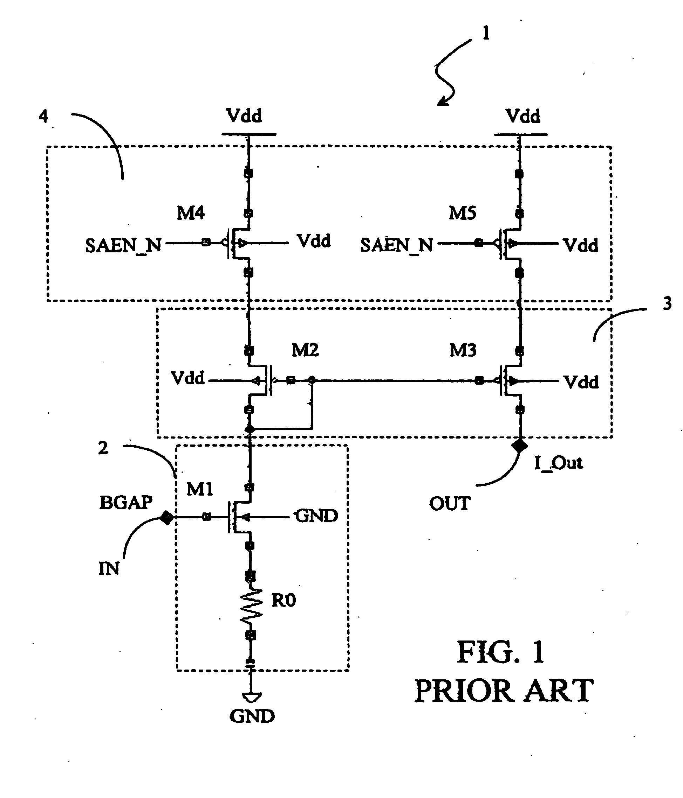

An embodiment of the sense amplifier architecture described, i.e. of the generation or bandgap circuitry, starting from a Band Gap voltage stable in temperature and power supply, of the controlled current is schematically shown in Figure 1, globally indicated with 1 and hereafter called Band Gap circuitry".

In particular, the Band Gap circuitry 1 essentially comprises a controlled current generator 2, a current mirror 3 and an enable circuitry 4, inserted, in cascade to each other, between a first and a second voltage reference, in particular a supply Vdd and a ground GND.

As above described, the controlled current generator 2 comprises an LV transistor M1, in particular of the MOS type with N channel, having a control terminal or gate connected to an input terminal IN of the Band Gap circuitry 1, receiving the Band Gap voltage BGAP, a first conduction terminal, in particular a source terminal, connected to the ground GND through a degeneration resistor R0 and a second conduction terminal, in particular a drain terminal, connected to the current mirror 3.

In turn, the current mirror 3 comprises a first mirror transistor M2, in particular of the MOS type with P channel, being diode configured, inserted between the enable circuitry 4 and the controlled current generator 2 and having a control terminal or gate connected to a control terminal or gate of a second mirror transistor M3, inserted between the enable circuitry 4 and an output terminal OUT of the Band Gap circuitry 1. On the output terminal OUT of the Band Gap circuitry 1 an output controlled current signal I_OUT is then generated.

Finally, the enable circuitry 4 comprises a first enable transistor M4 inserted between the supply reference Vdd and the first mirror transistor M2 of the current mirror 3 and having a control terminal or gate receiving an enable signal SAEN_N, as well as a second enable transistor M5 inserted between the supply reference Vdd and the second mirror transistor M3 of the current mirror 3 and having a control terminal or gate receiving the enable signal SAEN_N.

In the embodiment shown in the Figure, the LV transistor M1 of the controlled current generator 2 has a bulk terminal connected to the ground GND, while the mirror transistors M2 and M3 as well as the enable transistors M4 and M5 have bulk terminals connected to the supply voltage reference Vdd.

When the sense amplifier comprising the Band Gap circuitry 1 is switched on, the enable signal SAEN_N passes from a value corresponding to the supply reference Vdd to a ground value GND.

In an initial step, the drain terminal of the LV transistor M1 of the controlled current generator 2 is disconnected from the rest of the circuitry of the sense amplifier and the LV transistor M1 is on. Thus, the channel of this LV transistor M1 is formed and, through the degeneration resistor R0, it is at a ground potential value GND, usually 0V.

Under these conditions, also the drain terminal of the LV transistor M1 is thus at a ground potential value GND, i.e. at 0V potential.

At the switch on of the sense amplifier, the potential values of the source terminals of the transistors M2 and M3 of the current mirror 3 are brought to the value of the supply voltage reference Vdd and - in consequence - a current starts to flow in these transistors and the potential of the drain terminal of the LV transistor M1 enhances up to a value equal to a tripping voltage which enables the current mirror 3 to operate correctly.

With the enhancement of the potential of this drain terminal of the LV transistor M1 the channel is no more uniformly biased at the ground potential value GND.

Thus, due to its capacitive coupling to the channel and to the drain terminal, also the gate terminal of the LV transistor M1 tends to "move upwards", i.e. it tends to reach greater potential values thus creating a disturb in the Band Gap voltage value which is transferred onto the generated current value.

All this occurs in real situations, since the Band Gap voltage BGAP is not produced, obviously, by an ideal voltage generator and thus only after a certain period of time, indicated as disturb period, tins capacitive coupling disturb between terminals of the LV transistor M1 is recovered by the generator - real - of the Band Gap voltage BGAP.

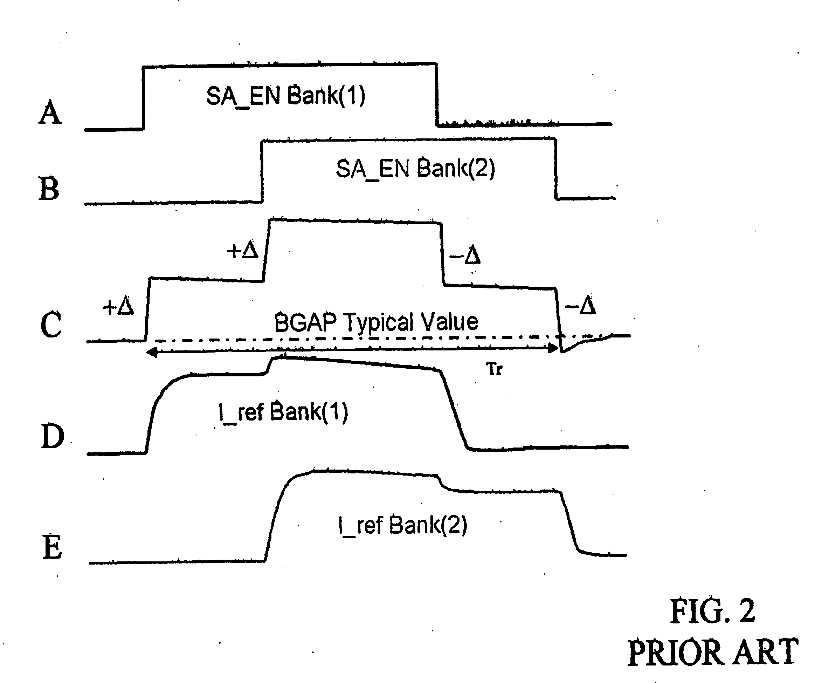

This mechanism of generation and recovery of the capacitive coupling disturb is schematically shown in Figure 2. In particular, in this Figure the diagrams A and B show a first and a second enable signal, SA_EN Bank(1) and SA EN Bank(2), which switch on and off (in correspondence with different time instants and for a high and low value of the enable signal, respectively) a first and a second bank of sense amplifiers, for example of a memory device of the Dual Work type.

The switch on of the banks of sense amplifiers changes the progress of the Band Gap voltage signal BGAP, as shown in the diagram C, in particular enhancing it in correspondence with the switch on of a bank of sense amplifiers and decreasing it in correspondence with its switch off, with overlapping of these enhancements and decreases in the case of different banks of sense amplifiers. As above explained, the diagram C shows how the Band Gap voltage BGAP departs from its ideal value BGAP Typical Value for the disturb period, indicated with Tr in the figure.

During the disturb period Tr also the controlled current reference values a bank of sense amplifiers is supplied with, indicated as I_ref Bank(1) and I_ref Bank(2) thus show a progress affected by the switch on and by the switch off of another bank, as the diagrams D and E of Figure 2 show.

In other words, the switch on/off of a bank of sense amplifiers affects the other banks of sense amplifiers in the memory device.

It is worthwhile to note, that, since the circuit node wherein the Band Gap voltage BGAP is present is shared (indicated as BGAP node) by all the sense amplifiers of a partition (and of all the partitions) of the memory device connected to these sense amplifiers and since the number of sense amplifiers per partition is very high (normally higher than 100) it is impossible to stabilise this BGAP node by simply "reinforcing" the Band Gap voltage generator BGAP, for example with an over-dimension of its output buffer.

It is also possible to locally interface the Band Gap voltage value BGAP for each partition of the memory device by means of a suitable analog buffer. In reality, such a solution is expensive in terms of area and/or of consumption.

Finally, it is possible to introduce a local filtering of the Band Gap voltage value BGAP by means of suitable resistors connected between each partition and the BGAP node, which is a strongly "capacitive" node. In this case, each resistor realises, with such a BGAP node, a low-pass filter.

In reality, by using such a local filtering, the value of the controlled current the sense amplifiers are supplied with is however locally disturbed inside the bank being switched on, the switch on occurrence however producing a much more modest effect on a possible further bank being already active. Moreover, the action of such a local filtering is slow.

In substance, we can say that memory devices realised up to now show the common problem of the mutual influence between the banks of sense amplifiers they contain, the switch on of a bank of sense amplifiers however introducing a disturb for another bank already on, with consequent potential reading errors.

US 2005/117408 Al discloses a circuit according to the preamble of independent claim 1.

According to EP-A-0 891 045 a circuit for reducing capacitive coupling between a culprit and a victim signal line is provided which comprises two inverters, a n-channel FET connected as a capacitor, and a p-channel FET connected as a capacitor. The input of both inverters are connected to the culprit line. The first inverter is designed to respond to high-to-low transition on the culprit line more rapidly than a low-to-high transition. The output of the first inverter is connected to the drain and source of the n-channel FET. The gate of the n-channel FET is connected to the victim line. The second inverter is designed to respond to low-to-high transition on the culprit line more rapidly than a high-to-low transition. The output of the second inverter is connected to the drain and source of the p-channel FET. The gate of the p-channel FET is connected to the victim line.

The technical problem underlying the present invention is that of devising a method for generating a controlled current and a respective bandgap circuitry, for example inside a sense amplifier, having such structural and functional characteristics as to allow to eliminate or in any case reduce the disturbances linked to the switching on and to the switching off of these circuitries.

### Summary of the Invention

According to a first aspect, the present invention provides a circuit for suppressing disturbances of a controlled current signal generated by a bandgap circuitry on a bandgap node, according to the subject-matter of claim 1. An embodiment of the invention is directed to a bandgap circuitry for generating a controlled current signal, according to the subject-matter of claim 16. Another aspect of the invention is directed to a method for generating a controlled current signal, according to the subject-matter of claim 17. Still further embodiments of the invention are set forth in the dependent claims, the following description and the drawings.

Further characteristics and the advantages of the method, of the circuit and the bandgap circuitry (hereinafter referred as to "Band Gap circuitry") according to the invention will be more apparent from the following description of embodiments thereof given by way of indicative and non limiting examples with reference to the annexed drawings.

### Brief description of the drawings

In these drawings:
- Figure 1: schematically shows a Band Gap circuitry, inside a sense amplifier and realised according to the prior art;
- Figure 2: schematically shows the progress of signals inside a first and a second bank of sense amplifiers equipped with the Band Gap circuitry of Figure 1;
- Figure 3: schematically shows a Band Gap circuitry realised according to the invention;
- Figure 4A and 4B: schematically show a circuit for suppressing disturbs inside the circuitry of Figure 3.

The following detailed description refers to embodiments of the invention and is given by way of indicative and non-limiting examples.

The present invention arises from the consideration that, in its most general form, a disturb or disturbance linked to the switching on of a sense amplifier must be locally suppressed, so as to avoid influencing the operation of a further sense amplifier already operating, for example in a memory device of the Dual Work type where these sense amplifiers are grouped in banks and can operate simultaneously.

In an embodiment of the invention, the step of locally suppressing a disturbance of a controlled current signal comprises a step of emulating a behaviour that is opposite to a behaviour of a circuit or load connected to the Band Gap circuitry, in particular a sense amplifier. In substance, the method provides that this emulating step influences the controlled current generated by the Band Gap circuitry in the opposite direction with respect to the influence of the load connected thereto, cancelling the disturb effects of this load on the controlled current thus generated.

Advantageously according to another embodiment of the invention, the emulating step particularly provides the use of a compensation capacitor connected to the Band Gap node and driven by an enable signal SAEN opposed to an enable signal SAEN_N of the Band Gap circuitry.

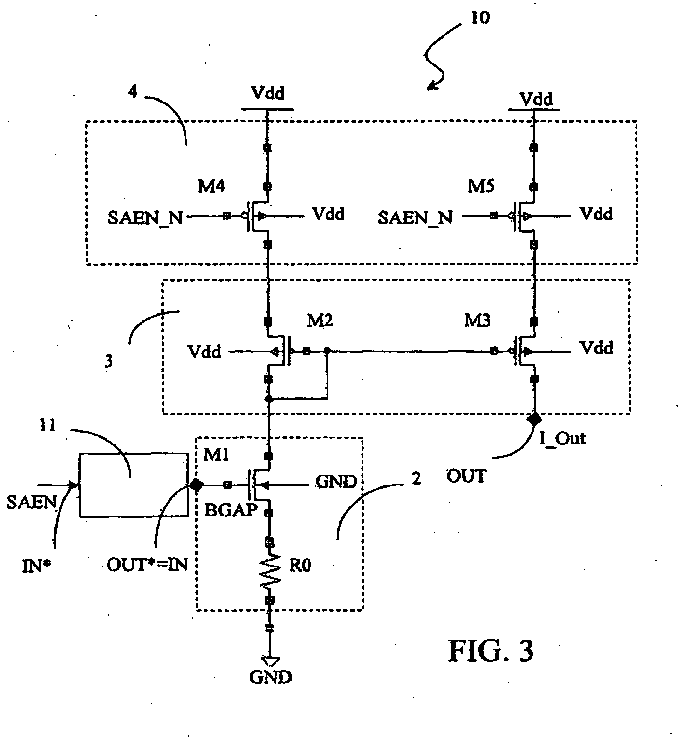

The method for generating a controlled current according to an embodiment of the invention is implemented by means of a Band Gap circuitry, schematically shown in Figure 3 and globally indicated with 10.

The Band Gap circuitry 10 has a base structure corresponding to the Band Gap circuitry 1 described in connection with the prior art and shown in Figure 1. Structurally and functionally identical elements will be given the same reference numbers by way of illustration.

The Band Gap circuitry 10 thus comprises, as previously seen, a controlled current generator 2, a current mirror 3 and an enable circuitry 4, cascade inserted between a first and a second voltage reference, in particular a supply voltage Vdd and a ground potential GND.

The current generator 2 comprises a LV transistor M1, in particular of the MOS type with N channel, having a control terminal or gate connected to an input terminal IN of the Band Gap circuitry 1, receiving the Band Gap voltage BGAP and corresponding to a Band Gap node BGAP, a first conduction terminal, in particular a source terminal, connected to the ground GND through a degeneration resistor RO and a second conduction terminal, in particular a drain terminal, connected to the current mirror 3.

In turn, the current mirror 3 comprises a first mirror transistor M2, in particular of the MOS type with P channel, diode configured, inserted between the enable circuitry 4 and the generator 2 of a Band Gap voltage and having a control terminal or gate connected to a control terminal or gate of a second mirror transistor M3, inserted between the enable circuitry 4 and an output terminal OUT of the Band Gap circuitry 1, where an output controlled current signal I_OUT is generated.

Finally, the enable circuitry 4 comprises a first enable transistor M4 inserted between the supply reference Vdd and the first mirror transistor M2 of the current mirror 3 and having a control terminal or gate receiving an enable signal SAEN_N, as well as a second enable transistor M5 inserted between the supply reference Vdd and the second mirror transistor M3 of the current mirror 3 and having a control terminal or gate receiving the enable signal SAEN_N.

Advantageously according to the invention, the Band Gap circuitry 10 also comprises a disturb suppression circuit 11, having an input terminal IN* receiving a further enable signal SAEN and an output terminal OUT* connected to the input terminal IN of the Band Gap circuitry 10. In particular, the disturb suppression circuit 11 realises the step of the local suppression of disturbs, as it will be apparent hereafter in the description.

In the embodiment shown in the Figure, the LV transistor M1 of the controlled current generator 2 has a bulk terminal connected to the ground GND, while the mirror transistors M2 and M3 as well as the enable transistors M4 and M5 have bulk terminals connected to the supply voltage reference Vdd.

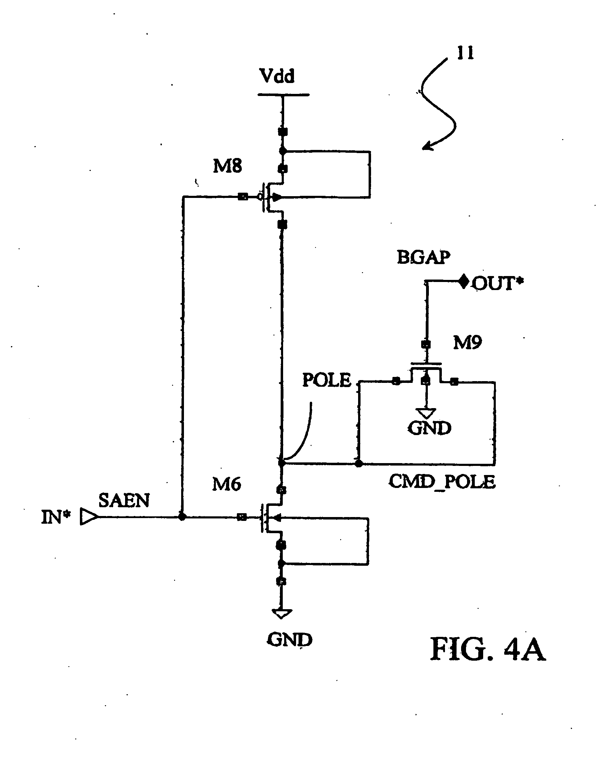

The disturb suppression circuit 11 realised according to the invention is shown in greater detail in Figure 4A.

In particular, the disturb suppression circuit 11 comprises an input transistor M6, in particular a MOS transistor with N channel, having a control terminal or gate connected to the input terminal IN* of the disturb suppression circuit 11, a first conduction terminal, in particular a drain terminal, connected to an inner circuit node POLE and a second conduction terminal, in particular a source terminal connected to the ground GND.

The inner circuit node POLE is connected, by means of a switch transistor M8, in particular a MOS transistor with P channel, to the supply voltage reference Vdd.

Advantageously according to the invention, the disturb suppression circuit 11 also comprises a compensation capacitor inserted between the inner circuit node POLE and the output terminal OUT* of the disturb suppression circuit 11. In the embodiment shown in Figure 4A, this compensation capacitor is realised by means of a further coupling transistor M9, in particular a MOS transistor with N channel, having the conduction terminals connected to the inner circuit node POLE and a control terminal or gate connected to the output terminal OUT*, in turn connected to the input terminal IN of the Band Gap circuitry 10 and receiving the Band Gap voltage BGAP.

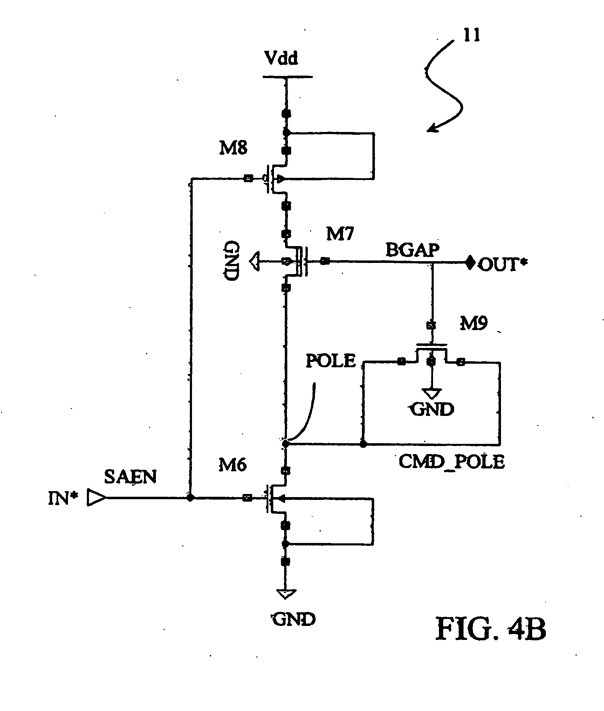

In a preferred embodiment of the disturb suppression circuit 11 according to the invention, shown in Figure 4B, a threshold transistor M7 is also inserted between the switch transistor M8 and the inner circuit node POLE.

In particular, the threshold transistor M7 has a control terminal or gate connected to the output terminal OUT*, a first conduction terminal, in particular a drain terminal, connected to the switch transistor M8 and a second conduction terminal, in particular a source terminal, connected to the inner circuit node POLE.

Moreover, the switch transistor M8 has a control terminal or gate connected to the input terminal IN*, a first conduction terminal, in particular a source terminal, connected to the supply voltage reference Vdd and a second conduction terminal, in particular a drain terminal, connected to the threshold transistor M7.

In the embodiment shown in Figure 4B, the threshold transistor M7 is a natural transistor in cascode configuration and it has a bulk terminal connected to the ground GND, while the switch transistor M8 has a bulk terminal connected to the supply voltage reference.

Finally, the coupling transistor M9 has a control terminal or gate connected to the output terminal OUT*, a first and a second conduction terminal connected to the inner circuit node POLE and a bulk terminal connected to the ground GND. The coupling transistor M9 thus serves as capacitor for compensating the variations introduced through capacitive coupling by the switch on and off of the circuits or loads connected to the Band Gap circuitry 10, in particular sense amplifiers.

It is worthwhile to note that on the inner circuit node POLE there is a control signal CMD_POLE, that the input terminal IN* receives the further enable signal SAEN, that is the inverted enable signal SAEN_N for the enable transistors M4 and M5 of the enable circuitry 4 and that the output terminal OUT* supplies a current signal BGAP compensated with the disturbs.

Let's now see the operation of the disturb suppression circuit 11 according to the invention, that substantially emulates a behaviour opposite with respect to the rest of the Band Gap circuitry 10 in correspondence with the switch on of a load, in particular a sense amplifier to whom this Band Gap circuitry 10 is connected.

Advantageously according to the invention, the disturb suppression circuit 11 provides that a capacitor (realised by the coupling transistor M9) is connected between the output terminal OUT*, where there is the Band Gap voltage signal BGAP, and the inner circuit node POLE, where the control signal CMD_POLE is applied so that the disturb suppression signal 11 has a behaviour opposed to the Band Gap circuitry 10 under on and off conditions of the same and thus of the load connected thereto, in particular a sense amplifier.

In particular, under off conditions of the sense amplifier, i.e. for high values of the enable signal SAEN_N of the enable circuitry 4, the further enable signal SAEN has a low value, in particular the ground value GND, and applies, the input transistor M6 being off, a positive voltage value to the inner circuit node POLE thanks to the switch on of the switch transistor M8. In its embodiment shown in Figure 4A, this positive voltage value is given by the supply voltage Vdd, while in the embodiment shown in Figure 4B, this positive voltage value is given by the Band Gap voltage BGAP decreased by a threshold voltage value Vth of the threshold transistor M7.

At the switch on of the sense amplifier, the enable signal SAEN_N is brought to a low value while the further enable signal SAEN is brought at a high value, in particular to the supply voltage value Vdd, switching on the input transistor M6 and forcing the inner circuit node POLE to a value corresponding to the ground GND. Under these conditions, the capacitor realised by the coupling transistor M9 decreases the potential value of the output terminal OUT*, i.e. of the Rand Gap voltage signal BGAT, compensating the behaviour of the rest of the Band Gap circuitry 10 which, as previously described in connection with the prior art, tends instead to enhance this Band Gap voltage signal BGAP.

Advantageously according to the invention, the value of the capacitor realised by the coupling transistor M9 and the variation of the potential of the control signal CMD_POLE are suitably calibrated for compensating at the best the behaviour of the rest of the Band Gap circuitry 10 and in particular the injection of positive charge created by the switch on of the current mirror 3.

In particular, when the sense amplifier is off, the control signal CMD_POLE is brought to a value equal to the supply voltage Vdd. In this case, a little noisy supply voltage reference is to be provided, to avoid introducing, through capacitive coupling, this noise on the output terminal OUT*, i.e. on the Band Gap node.

As it has been seen in a preferred embodiment of the disturb suppression circuit 11, if the disturb suppression circuit 11 includes the threshold transistor M7, the control signal CMD_POLE is brought to a value equal to the Band Gap voltage BGAP decreased by a threshold voltage value of the threshold transistor M7.

In a further preferred embodiment, the threshold transistor M7 is a natural transistor, thus having a very little threshold voltage value, connected to the output terminal OUT* in a cascode configuration. In this way, the threshold transistor M7 allows to de-couple the supply voltage reference Vdd from the output terminal OUT*, i.e. from the Band Gap node.

It is also possible to use a threshold transistor M7 realised by a Low Voltage transistor, to further improve the de-coupling between the supply voltage reference Vdd and Band Gap node. In this case, the control signal CMD_POLE has however definitely low voltage values, which must be suitably managed.

Finally, the transistor M9 which realises the coupling capacitor with the Band Gap node DGAP is a Low Voltage transistor having dimensions that can be compared with those of the LV transistor M1 of the controlled current generator 2, to obtain a better emulation of the opposite behaviour of the Band Gap circuitry 10 under on and/or off conditions.

It is obvious that similar considerations are also valid in case of off conditions. In particular, the following conditions are valid:
- if the sense amplifier is off (OFF), the input transistor M6 is off (OFF) and the switch transistor M8 is on (ON); while
- if the sense amplifier is on (ON), the input transistor M6 is on (ON) and the switch transistor M8 is off (OFF).

In conclusion, the method for generating a controlled current, the circuit for suppressing disturbs and the Band Gap circuitry realised according to the invention allow to compensate the disturbs introduced through capacitive coupling by the switch on/off of sense amplifiers on a sense amplifier already operating and attain several advantages among which an incredible functional and structural simplicity of the circuits proposed, which allow an easy regulation of their operation together with a containment of the costs and of the areas necessary for realising them.

Moreover, advantageously according to the invention, the method for generating a regulated current has a beneficial effect also on the self-induced disturbs, i.e. on the operation disturbs of a sense amplifier linked to the switch on of the other sense amplifiers belonging to a same bank. In particular, the disturb compensation obtained ensurcs the correct operation of all the sense amplifiers of a bank, independently from the switch on/off conditions of the other sense amplifiers of this bank.

## Claims

1. A circuit for suppressing disturbances of a controlled current signal generated by a bandgap circuitry on a bandgap node (BGAP), comprising:
at least one compensation capacitor (M9) connected between said bandgap node (BGAP) and an inner circuit node (POLE) of the circuit that is connected to a first voltage reference (GND) via an input transistor (M6) having a control terminal connected to an input terminal (IN*) of the circuit (11) and receiving an enable signal (SAEN), and
at least one switch (M8) coupled between said second voltage reference (Vdd) and said inner circuit node (POLE),
**characterised by**
at least one threshold transistor (M7) connected between said switch (M8) and said inner circuit node (POLE) and having a control terminal coupled to said bandgap node (BGAP).

2. The circuit of claim 1, **characterised in that** said compensation capacitor comprises a transistor (M9) having a control terminal connected to said bandgap node (BGAP) and conduction terminal connected to said inner circuit node (POLE).

3. The circuit of claim 2, **characterised in that** said transistor (M9) is a MOS transistor with N channel.

4. The circuit of claim 3, **characterised in that** said transistor (M9) has a bulk terminal connected to said first voltage reference (GND).

5. The circuit of claim 4, **characterised in that** said transistor (M9) is a low voltage transistor.

6. The circuit of claim 1, **characterised in that** said input transistor (M6) has a first conduction terminal connected to said inner circuit node (POLE) and a second conduction terminal connected to said first voltage reference (GND).

7. The circuit of claim 6, **characterised in that** said input transistor (M6) is a MOS transistor with N channel.

8. The circuit of claim 7, **characterised in that** said input transistor (M6) has a bulk terminal connected to said first voltage reference (GND).

9. The circuit of claim 1, **characterised in that** said switch is a transistor (M8) having a control terminal connected to said input terminal (IN*), a first conduction terminal connected to said second voltage reference (Vdd) and a second conduction terminal connected to said inner circuit node (POLE).

10. The circuit of claim 9, **characterised in that** said transistor (M8) is a MOS transistor with P channel.

11. The circuit of claim 10, **characterised in that** said transistor (M8) has a bulk terminal connected to said second voltage reference (Vdd).

12. The circuit of claim 1, **characterised in that** said threshold transistor (M7) is a natural transistor in cascode configuration.

13. The circuit of claim 12, **characterised in that** said threshold transistor (M7) has a bulk terminal connected to said first voltage reference (GND).

14. The circuit of claim 1, **characterised in that** said threshold transistor (M7) is a low voltage transistor.

15. A bandgap circuitry (10)for generating a controlled current signal, comprising a circuit (11) according to any one of claims 1 to 14.

16. A method for generating a controlled current signal by means of a bandgap circuitry, comprising:
supplying, on a bandgap node, a bandgap voltage signal;
driving a controlled current generator by means of said bandgap voltage signal;
suppressing a disturbance of a controlled current signal generated by the controlled current generator by means of a disturbance suppression circuit (11), according to any one of claims 1 to 14, connected to said bandgap node acting on said bandgap voltage signal; and
mirroring said controlled current signal generated on an output terminal of said bandgap circuitry.

17. The method of claim 16, **characterised in that** said step of locally suppressing said disturbance of said controlled current signal comprises emulating a behaviour that is opposite to a behaviour of a load circuit connected to said bandgap circuitry.

18. The method of claim 16, **characterised in that** said emulating provides for the use of a compensation capacitor (M9) connected to said bandgap node and driven by an enable signal (SAEN) opposite to an enable signal (SAEN_N) of said bandgap circuitry.

## Patentansprüche

1. Schaltung zur Unterdrückung von Störungen eines gesteuerten Stromsignals, das durch eine Bandgap-Schaltung an einem Bandgap-Knoten (BGAP) erzeugt wird, umfassend:
wenigstens einen Kompensationskondensator (M9), der zwischen den Bandgap-Knoten (BGAP) und einen inneren Schaltungsknoten (POLE) der Schaltung geschaltet ist, der mit einer ersten Spannungsreferenz (GND) über einen Eingangstransistor (M6) verbunden ist, der einen Steueranschluss aufweist, der mit einem Eingangsanschluss (IN*) der Schaltung (11) verbunden ist und ein Aktivierungssignal (SAEN) empfängt, und
wenigstens einen Schalter (M8), der zwischen die zweite Spannungsreferenz (Vdd) und den inneren Schaltungsknoten (POLE) gekoppelt ist,
**gekennzeichnet durch**
wenigstens einen Schwellwerttransistor (M7), der zwischen den Schalter (M8) und den inneren Schaltungsknoten (POLE) geschaltet ist und einen Steueranschluss aufweist, der mit dem Bandgap-Knoten (BGAP) gekoppelt ist.

2. Schaltung nach Anspruch 1, **dadurch gekennzeichnet, dass** der Kompensationskondensator einen Transistor (M9) umfasst, der einen Steueranschluss aufweist, der mit dem Bandgap-Knoten (BGAP) verbunden ist, und einen Leitungsanschluss, der mit dem inneren Schaltungsknoten (POLE) verbunden ist.

3. Schaltung nach Anspruch 2, **dadurch gekennzeichnet, dass** der Transistor (M9) ein MOS-Transistor mit n-Kanal ist.

4. Schaltung nach Anspruch 3, **dadurch gekennzeichnet, dass** der Transistor (M9) einen Bulk-Anschluss aufweist, der mit der ersten Spannungsreferenz (GND) verbunden ist.

5. Schaltung nach Anspruch 4, **dadurch gekennzeichnet, dass** der Transistor (M9) ein Niederspannungstransistor ist.

6. Schaltung nach Anspruch 1, **dadurch gekennzeichnet, dass** der Eingangstransistor (M6) einen ersten Leitungsanschluss aufweist, der mit dem inneren Schaltungsknoten (POLE) verbunden ist und einen zweiten Leitungsanschluss, der mit der ersten Spannungsreferenz (GND) verbunden ist.

7. Schaltung nach Anspruch 6, **dadurch gekennzeichnet, dass** der Eingangstransistor (M6) ein MOS-Transistor mit n-Kanal ist.

8. Schaltung nach Anspruch 7, **dadurch gekennzeichnet, dass** der Eingangstransistor (M6) einen Bulk-Anschluss aufweist, der mit der ersten Spannungsreferenz (GND) verbunden ist.

9. Schaltung nach Anspruch 1, **dadurch gekennzeichnet, dass** der Schalter ein Transistor (M8) ist, der einen Steueranschluss, der mit dem ersten Eingangsanschluss (IN*) verbunden ist, einen ersten Leitungsanschluss, der mit der zweiten Spannungsreferenz (Vdd) verbunden ist, und einen zweiten Leitungsanschluss, der mit dem inneren Schaltungsknoten (POLE) verbunden ist, aufweist.

10. Schaltung nach Anspruch 9, **dadurch gekennzeichnet, dass** der Transistor (M8) ein MOS-Transistor mit p-Kanal ist.

11. Schaltung nach Anspruch 10, **dadurch gekennzeichnet, dass** der Transistor (M8) einen Bulk-Anschluss aufweist, der mit der zweiten Spannungsreferenz (Vdd) verbunden ist.

12. Schaltung nach Anspruch 1, **dadurch gekennzeichnet, dass** der Schwellwerttransistor (M7) ein normaler Transistor in Kaskodenanordnung ist.

13. Schaltung nach Anspruch 12, **dadurch gekennzeichnet, dass** der Schwellwerttransistor (M7) einen Bulk-Anschluss aufweist, der mit der ersten Spannungsreferenz (GND) verbunden ist.

14. Schaltung nach Anspruch 1, **dadurch gekennzeichnet, dass** der Schwellwerttransistor (M7) ein Niederspannungstransistor ist.

15. Bandgap-Schaltung (10) zum Erzeugen eines gesteuerten Stromsignals, umfassend eine Schaltung (11) nach einem der Ansprüche 1 bis 14.

16. Verfahren zum Erzeugen eines gesteuerten Stromsignals mittels einer Bandgap-Schaltung, umfassend:
Anlegen eines Bandgap-Spannungssignals an einen Bandgap-Knoten;
Betreiben eines gesteuerten Stromgenerators mittels des Bandgap-Spannungssignals;
Unterdrücken einer Störung eines gesteuerten Stromsignals, das durch den gesteuerten Stromgenerator erzeugt wird, mittels einer Störungsunterdrückungsschaltung (11) nach einem der Ansprüche 1 bis 14, die mit dem Bandgap-Knoten verbunden ist, die auf das Bandgap-Spannungssignal wirkt; und
Spiegeln des gesteuerten Stromsignals, das auf einem Ausgangsanschluss der Bandgap-Schaltung erzeugt wird.

17. Verfahren nach Anspruch 16, **dadurch gekennzeichnet, dass** der Schritt des lokalen Unterdrückens der Störung des gesteuerten Stromsignals Emulieren eines Verhaltens umfasst, das entgegengesetzt zu einem Verhalten einer Lastschaltung ist, die mit der Bandgap-Schaltung verbunden ist.

18. Verfahren nach Anspruch 16, **dadurch gekennzeichnet, dass** das Emulieren die Verwendung eines Kompensationskondensators (M9) gewährleistet, der mit dem Bandgap-Knoten verbunden ist und durch ein Aktivierungssignal (SAEN) betrieben wird, das gegensätzlich zu einem Aktivierungssignal (SAEN_N) der Bandgap-Schaltung ist.

## Revendications

1. Circuit pour supprimer des perturbations d'un signal de courant régulé généré par des éléments de circuit de bande interdite sur un noeud de bande interdite (BGAP), comprenant :
> au moins un condensateur de compensation (M9) connecté entre ledit noeud de bande interdite (BGAP) et un noeud de circuit interne (POLE) du circuit qui est connecté à une première référence de tension (GND) par l'intermédiaire d'un transistor d'entrée (M6) ayant une borne de commande connectée à une borne d'entrée (IN*) du circuit (11) et recevant un signal de validation (SAEN), et
> au moins un commutateur (M8) couplé entre ladite deuxième référence de tension (Vdd) et ledit noeud de circuit interne (POLE),
**caractérisé par**
> au moins un transistor à seuil (M7) connecté entre ledit commutateur (M8) et ledit noeud de circuit interne (POLE) et ayant une borne de commande couplée audit noeud de bande interdite (BGAP).

2. Circuit selon la revendication 1, **caractérisé en ce que** ledit condensateur de compensation comprend un transistor (M9) ayant une borne de commande connectée audit noeud de bande interdite (BGAP) et une borne de conduction connectée audit noeud de circuit interne (POLE).

3. Circuit selon la revendication 2, **caractérisé en ce que** ledit transistor (M9) est un transistor MOS avec un canal N.

4. Circuit selon la revendication 3, **caractérisé en ce que** ledit transistor (M9) a une borne de substrat connectée à ladite première référence de tension (GND).

5. Circuit selon la revendication 4, **caractérisé en ce que** ledit transistor (M9) est un transistor basse tension.

6. Circuit selon la revendication 1, **caractérisé en ce que** ledit transistor d'entrée (M6) a une première borne de conduction connectée audit noeud de circuit interne (POLE) et une deuxième borne de conduction connectée à ladite première référence de tension (GND).

7. Circuit selon la revendication 6, **caractérisé en ce que** ledit transistor d'entrée (M6) est un transistor MOS avec un canal N.

8. Circuit selon la revendication 7, **caractérisé en ce que** ledit transistor d'entrée (M6) a une borne de substrat connectée à ladite première référence de tension (GND).

9. Circuit selon la revendication 1, **caractérisé en ce que** ledit commutateur est un transistor (M8) ayant une borne de commande connectée à ladite borne d'entrée (IN*), une première borne de conduction connectée à ladite deuxième référence de tension (Vdd) et une deuxième borne de conduction connectée audit noeud de circuit interne (POLE).

10. Circuit selon la revendication 9, **caractérisé en ce que** ledit transistor (M8) est un transistor MOS avec un canal P.

11. Circuit selon la revendication 10, **caractérisé en ce que** ledit transistor (M8) a une borne de substrat connectée à ladite deuxième référence de tension (Vdd).

12. Circuit selon la revendication 1, **caractérisé en ce que** ledit transistor à seuil (M7) est un transistor naturel dans une configuration cascode.

13. Circuit selon la revendication 12, **caractérisé en ce que** ledit transistor à seuil (M7) a une borne de substrat connectée à ladite première référence de tension (GND).

14. Circuit selon la revendication 1, **caractérisé en ce que** ledit transistor à seuil (M7) est un transistor basse tension.

15. Eléments de circuit de bande interdite (10) pour générer un signal de courant régulé, comprenant un circuit (11) selon l'une quelconque des revendications 1 à 14.

16. Procédé pour générer un signal de courant régulé au moyen d'éléments de circuit de bande interdite, consistant à :
> appliquer, à un noeud de bande interdite, un signal de tension de bande interdite ;
> commander un générateur de courant régulé au moyen dudit signal de tension de bande interdite ;
> supprimer une perturbation d'un signal de courant régulé généré par le générateur de courant régulé au moyen d'un circuit de suppression de perturbation (11), selon l'une quelconque des revendications 1 à 14, connecté audit noeud de bande interdite agissant sur ledit signal de tension de bande interdite ; et
> générer un signal miroir dudit signal de courant régulé généré sur une borne de sortie desdits éléments de circuit de bande interdite.

17. Procédé selon la revendication 16, **caractérisé en ce que** ladite étape de suppression locale de ladite perturbation dudit signal de courant régulé comprend l'émulation d'un comportement qui est opposé à un comportement d'un circuit de charge connecté auxdits éléments de circuit de bande interdite.

18. Procédé selon la revendication 16, **caractérisé en ce que** ladite émulation prévoit l'utilisation d'un condensateur de compensation (M9) connecté audit noeud de bande interdite et commandé par un signal de validation (SAEN) opposé à un signal de validation (SAEN_N) desdits éléments de circuit de bande interdite.
